# EUROPÄISCHE PATENTSCHRIFT

(11) **EP 1 678 744 B1**
(45) Veröffentlichungstag und Bekanntmachung des Hinweises auf die Patenterteilung: **06.06.2012**
(21) Anmeldenummer: 04790539.3
(22) Anmeldetag: 18.10.2004
(51) Int. Cl.: H01L 21/67, H01L 21/68

(54) **POSITIONIERUNGSVORRICHTUNG UND VERFAHREN FÜR DIE ÜBERTRAGUNG ELEKTRONISCHER BAUTEILE**
POSITIONING DEVICE AND METHOD FOR TRANSFERRING ELECTRONIC COMPONENTS
DISPOSITIF ET PROCEDE DE POSITIONNEMENT POUR TRANSFERER DES COMPOSANTS ELECTRONIQUES

(30) Priorität: 25.10.2003 DE 10349847
(43) Veröffentlichungstag der Anmeldung: 12.07.2006
(73) Patentinhaber: Mühlbauer AG, 93426 Roding (DE)
(72) Erfinder: SCHILLER, Gerhard, 93426 Roding (DE)
(74) Vertreter: Schmidt, Steffen J.
(86) Internationale Anmeldenummer: PCT/EP2004/011703
(87) Internationale Veröffentlichungsnummer: WO 2005/041274

(56) Entgegenhaltungen:
- DE-A- 19 738 922
- US-A- 4 896 418
- PATENT ABSTRACTS OF JAPAN Bd. 1997, Nr. 04, 30. April 1997 (1997-04-30) -& JP 08 330393 A (MATSUSHITA ELECTRIC IND CO LTD), 13. Dezember 1996 (1996-12-13)

## Beschreibung

Die Erfindung betrifft eine Positionierungsvorrichtung und ein Positionierungsverfahren für die Übertragung mindestens eines elektronischen Bauteils von einem ersten flachen Träger auf mindestens eine vorbestimmte Stelle eines sich parallel dazu erstreckenden zweiten flachen Trägers mit einer Ausstoßeinrichtung zur Entnahme des Bauteils von dem ersten Träger mittels einer Ausstoßbewegung gemäß den Oberbegriffen der Patentansprüche 1 und 14.

Herkömmlicherweise werden für die Herstellung von Smart Labels Halbleiterchips mittels einer als Flipper bezeichneten Entnahmevorrichtung von einem auf einer als erster Träger agierenden Folie aufgespannten Wafer entnommen. In derartigen Flipchip-Maschinen wird der entnommene Chip oder Dice von dem Flipper geflippt, also dessen Ober-und Unterseite vertauscht, um anschließend mittels eines Pick-and-Place-Systems zu einem einen zweiten flachen Träger darstellenden Substrat transportiert und darauf angeordnet zu werden.

Da zwischen der Entnahmeposition der den Wafer tragenden Folie und einer vorbestimmten Stelle des Substrates, die die Bond-Kontakte für das Bonden des Chips auf dem Substrat aufweist, eine im Vergleich zu der Chipgröße relativ große Entfernung zurückzulegen ist, ist für das Sicherstellen einer genauen Positionierung des Chips oder des Dice auf dem zu bestückenden Substrat eine technisch aufwendige Flipchip-Bonder-Maschine erforderlich. Derartige Maschinen weisen hohe Herstellungskosten, erhöhte Reparaturanfälligkeit aufgrund ihrer aufwendigen Konstruktion und geringen Durchsatz aufgrund der langen Transportwege für die Flipchips auf.

DE 197 38 922 A1 offenbart eine Vorrichtung zum Bestücken eines Leadframes mit einer integrierten Schaltung, wobei die integrierten Schaltungen mittels einem Auswerfer an einer bestimmten Position von einer Folie gelöst und gegen einen Leadframe gedrückt werden. Dabei werden sowohl die Folie als auch der Leadframe bewegt, und über eine Kamera erfolgt eine Positionierung des Leadframes und der integrierten Schaltung auf der Folie zueinander. Die Kamera ist oberhalb des Auswerfers angeordnet und durch Schlitze bzw. Aussparungen im Leadframe erfolgt die Erfassung der integrierten Schaltung, die sich auf der Folie befindet. Über eine Bildverarbeitungseinheit werden die aufgenommenen Bilder verarbeitet und daraus die Positionierung berechnet.

In der US Patentschrift 4,896,418 wird ein Verfahren zum Aufbringen von Halbleiterbauteilen auf einen Leadframe offenbart. In diesem Verfahren werden Halbleiterbauteile von einer Folie über einen Leadframe gebracht und durch eine transparente Einrichtung von der Folie auf den Leadframe gedrückt. Oberhalb der transparenten Einrichtung ist eine Kamera angeordnet, die zur Ausrichtung des auf der Folie aufgebrachten Halbleiterbauteils über einer definierten Position des Leadframes dient.

DE 197 34 317 A1 beschreibt einen Bonder zum Bonden von Halbleiterchips auf eine Bondposition darstellende vorbestimmte Stelle eines zweiten Trägers, der ein Substrat darstellt. Bei dieser Vorrichtung werden zunächst mittels einer Vermessungseinrichtung Positionsdaten der einzelnen innerhalb des expandierten Wafers angeordneten Dice erfasst und gespeichert. Anschließend wird der den ersten Träger darstellende expandierte Wafer mit dem zu entnehmenden Chip über die vorbestimmte Stelle des zweiten Trägers, welche die Position der Bondkontakte des damit zu verbindenden Chips darstellt, positioniert. Anschließend findet mittels einer Ausstoßbewegung das rückseitige Ausstoßen und damit Sichlösen der Dice von der Folie dadurch statt, dass eine Ausstoßnadel auf eine Rückseite des Dice von oben wirkt. Der Dice wird dadurch direkt auf die vorbestimmte Stelle des Substrates platziert.

Hierfür findet ein Positionierungsvorgang der abzulösenden Dice gegenüber der vorbestimm- ten Stelle des Substrates mittels der zuvor erfassen Positionierungsdaten, die die Vermessungseinrichtung aufgenommen hat, statt. Da zwischen der Erfassung der Positionierungsdaten mittels der Vermessungseinrichtung und der Übertragung des Dice von dem Wafer beziehungsweise der Folie auf das Substrat eine Verschiebung des Wafers und damit der zu entnehmenden Dice erforderlich ist, um die Dice oberhalb der vorbestimmten Stelle des Substrates anordnen zu können, besteht aufgrund sich ändernder Spannungen der Trägerfolie die Gefahr einer zwischenzeitlichen Verschiebung der in ihren Positionsdaten bereits er- fassten Dice auf der Trägerfolie. Dies hat zur Folge, dass eine genaue Positionierung der zu entnehmenden Dice oberhalb der vorbestimmten Stelle des Substrates nicht mehr möglich ist. Dies trifft insbesondere bei der Verwendung von sehr kleinen Dice innerhalb sehr großer Wafer, die sich in eine Vielzahl von Dice aufteilen, und bei der Verwendung von sehr kleinen Bondkontakten, die innerhalb der vorbestimmten Stelle bereits auf dem Substrat angeordnet sind, zu.

Zudem erfolgt bei derartigen Übertragungsvorrichtungen keine direkte Erfassung der Positionsdaten der Bondkontakte an derjenigen Stelle, an der der Bondvorgang durchgeführt werden soll. Vielmehr wird ein indirektes eindimensionales Positionieren der Bondkontakte durch ein Positionieren des bandartigen Substrates, auf welchem die Bondkontakte angeordnet sind, mittels Antriebsrollen durchgeführt. Dies hat aufgrund von vorhandenen Materialtoleranzen und Positionsfehlern Positionierungsfehler bezüglich der Positionierung der vorbe- stimmten Stelle zur Folge.

Weiterhin weist die dargestellte Vorrichtung keine Positionierungseinrichtung zum Positionieren der Ausstoßeinrichtung im Bezug auf die Position der zu entnehmenden Dice und der vorbestimmten Stelle auf. Dies kann ebenso eine mögliche Fehlerquelle für eine nicht ausreichend genaue Positionierung der vorbestimmten Stelle gegenüber der zu entnehmenden Dice und der Ausstoßeinrichtung und damit für ein genaues Anordnen der Dice auf den Bondkontakten sein.

Demzufolge liegt der vorliegenden Erfindung die Aufgabe zugrunde, eine Positionierungsvorrichtung für die Übertragung elektronischer Bauteile von einem ersten Träger auf einen zwei- ten Träger zur Verfügung zu stellen, die zuverlässig ein Anordnen der Bauteile auf vorbe- stimmte Stellen des zweiten Trägers mit hoher Genauigkeit sicherstellt. Es ist ebenso Aufgabe der Erfindung, ein Positionierungsverfahren für die Übertragung der Bauteile von dem ersten auf den zweiten Träger zur Verfügung zu stellen, das ein Anordnen der Bauteile auf vorbestimmte Stellen des zweiten Trägers mit hoher Genauigkeit sicherstellt.

Diese Aufgabe wird vorrichtungsseitig durch die Merkmale des Patentanspruches 1 und verfahrensseitig durch die Merkmale des Patentanspruches 14 gelöst.

Bei einer Positionierungsvorrichtung für die Übertragung mindestens eines elektronischen Bauteils von einem ersten flachen Träger auf mindestens eine vorbestimmte Stelle eines sich parallel dazu erstreckenden zweiten flachen Trägers mit einer Ausstoßeinrichtung zur Entnahme des Bauteils von dem ersten Träger mittels einer Ausstoßbewegung ist eine Kameraeinrichtung zur Erfassung von Positionsdaten angeordnet, wobei die Kameraeinrichtung auf einer ge-dachten gemeinsamen Geraden mit der vorbestimmten Stelle auf dem zweiten Träger, dem zu entnehmenden Bauteil und der Ausstoßeinrichtung angeordnet ist. Auf diese Weise können die Positionsdaten der im Wesentlichen auf einer Achse angeordneten Teile beziehungsweise Einrichtungen, nämlich der Ausstoßeinrichtung, des abzulösenden Chips und der vorbestimmten Stelle auf dem zweiten Träger, in welcher Bondkontakte für den zu bondenden Chip angeordnet sind, an demjenigen Ort erfasst werden, an dem der eigentliche Bondvorgang stattfindet. Dies hat zur Folge, dass eine gegenseitige Ausrichtung des Chips, der Bondkontakte und der Ausstoßeinrichtung unter Kontrolle der die Positionsdaten erfassenden Kameraeinrichtung direkt am Ort des durchzuführenden Bondvorganges stattfinden kann. Hierdurch ergibt sich eine Übereinanderpositionierung dieser drei Elemente mit hoher Genauigkeit, die auch eine einfache nachträgliche Korrektur bei Abweichungen zulässt. Zwischen der Kameraeinrichtung und dem darüber angeordneten bandartigen Substrat ist zusätzlich ein flächenhaftes Auflageelement, das aus einem optisch transparentem Material besteht, zum Auflegen eines Teils des bandartigen Substrates angeordnet. Aufgrund der Verwendung eines transparenten Materials hält die darunter angeordnete Kameraeinrichtung optischen Kontakt zu den darüber angeordneten Bondkontakten, dem zu entnehmenden Chip und der Ausstoßeinrichtung, um deren Positionsdaten zu erfassen.

Der erste Träger, der eine Trägerfolie, auf welcher ein Wafer angeordnet ist, dar- stellen kann, ist mit einer ersten und der zweite Träger, der als bandartiges Substrat ausgebildet sein kann, ist mit einer zweiten Positionierungseinrichtung zur Positionierung der beiden Träger bezüglich der gemeinsamen Geraden verbunden. Die erste und zweite Positionierungseinrichtung führen jeweils eine Verschiebung des ersten und des zweiten flachen Trägers in deren Trägerebenen durch, wobei gemäß einer Ausführungsform zusätzlich eine Rotationsbewegung um eine senkrecht zu den Trägerebenen stehende Rotationsachse möglich ist. Eine derartige Rotationsbewegung wird vorteilhafterweise mit dem ersten Träger durchgeführt, um eine Ausrichtung des Wafers und damit eines einzelnen aus diesem Wafer zu entnehmenden Chips bezüglich des Substratbandes und der darauf angebrachten Bondkontakte zu erhalten. Die zweite Positionierungseinrichtung welche dem Substratband zugeordnet ist, weist hingegen vorteilhaft Verschiebungseinrichtungen für das Ver- schieben des Bandes in X-und vorzugsweise zusätzlich Y-Richtung, welche beide innerhalb der Trägerebene liegen, auf.

Demgegenüber kann eine der Ausstoßeinrichtung wahlweise zugeordnete zusätzliche Positionierungseinrichtung nicht nur in X-und Y-Richtung, sondern auch in Z-Richtung verschoben werden, um eine Ausstoßbewegung, die von oben auf eine Rückseite des abzulösenden Chips wirkt, durchzuführen.

Das bandartige Substrat besteht aus einem optisch transparenten Material oder aus einem teilweise durchbrochenen Material, um so einen optischen Kontakt der Kameraeinrichtung von unten auf den zu entnehmenden Chip und die Ausstoßeinrichtung zu ermöglichen. Bei einem sich anschließenden Verschieben des band- artigen Substrates werden mittels der Kameraeinrichtung zusätzlich die Positionsdaten der Bondkontakte erfasst und mittels einer Auswerteeinrichtung und einer auf die Positionierungsrichtungen wirkende Steuereinrichtung ein Ausrichten der drei Elemente zueinander bewirkt. Hierfür ist zu berücksichtigen, dass weitere bereits vor der Übertragung des Chips aufgebrachte Bauteile, wie beispielsweise Antennenschleifen, auf dem bandartigen Substrat angeordnet sind und den optisch transparenten Bereich des Substrates unterbrechen.

Die Auflagefläche des Auflageelements kann beheizbar sein, um den Bondvorgang durch Heizeinwirkung zu beschleunigen beziehungsweise zu verbessern. Das Auflageelement kann derart ausgebildet sein, dass es in z-Richtung, als auf- und abwärts bewegbar, insbesondere verschiebbar ist.

Ein Positionierungsverfahren für die Übertragung des elektronischen Bauteils von dem ersten flachen Träger auf die vorbestimmte Stelle des sich parallel dazu erstreckenden zweiten flachen Trägers weist folgende Schritte auf :
- Verschieben des zweiten flachen Trägers entlang seiner Trägerebene unterhalb des ersten flachen Trägers;
- Erfassen von Positionsdaten des auf dem ersten Träger angeordneten Chips mittels der unterhalb des aus zumindest stellenweise optisch transparentem Material bestehenden zweiten Trägers angeordneten Kameraeinrichtung während des Verschiebens des zweiten Trägers;
- Positionierung einer vorbestimmten Stelle des zweiten Trägers oberhalb der Kameraeinrichtung;
- Erfassen der Positionsdaten der vorbestimmten Stelle mittels der Kameraeinrichtung und
- Ausrichten des ersten Trägers, wahlweise der Ausstoßeinrichtung und/oder des zweiten Trägers mittels damit verbundener Positionierungseinrichtungen durch Verschieben und/oder Verdrehen derjenigen zueinander innerhalb der Trägerebenen. Hierbei ist die Kameraeinrichtung zusammen mit der vorbestimmten Stelle des zweiten Trägers, dem auf dem ersten Träger angeordneten zu entnehmenden Chip und der Ausstoßeinrichtung auf einer gedachten gemeinsamen Gerade angeordnet.

Zudem wird der als bandartiges Substrat ausgebildete zweite Träger dabei in seiner Trägerebene mit einer Verschiebungsgeschwindigkeit, die sich aus dem Abstand der von dem ersten Träger sukzessive zu entnehmenden Chips, einer Verschiebungsgeschwindigkeit des ersten Trägers und den Positionsdaten eines optisch transparenten Bereiches des zweiten Trägers, durch welche die Kameraeinrichtung Positionsdaten während des Verschiebens des zweiten Trägers erfasst, berechnet. Somit ist die Verwendung von sogenannten Wafer-Map-Dateien, die von Wafer-Hersteilfirmen zur Verfügung gestellt werden, derart möglich, dass deren Positions- Informationsdaten zu jedem funktionierenden Dice innerhalb eines Wafers als Abstandsdaten verwendet werden können und sich hieraus die Größe des benötigten Zeitfensters für die Positionserfassung des Dice und damit auch die maximale Transportgeschwindigkeit des Substrates errechnen lässt. Durch eine derartig dynamische Anpassung der Verschiebungsgeschwindigkeit des Substrates wird ein störungsfreier Ablauf bei maximal möglichem Maschinendurchsatz erreicht.

Auf diese Weise ergibt sich vorteilhaft eine Erfassung der Positionsdaten des zu bondenden und noch nicht abgelösten Chips zeitgleich mit einem Transport des bandartigen Substrates, wodurch sich nicht nur eine erhebliche Zeitersparnis und damit ein höherer Durchsatz einer Bondmaschine ergibt, sondern auch eine zusätzliche Messeinrichtung zur Bestimmung der Position eines Chips auf dem Wafer, wie sie bisher verwendet wurde, sich erübrigt.

Weitere Ausführungsformen ergeben sich aus den Unteransprüchen.

Vorteile und Zweckmäßigkeiten sind der nachfolgenden Beschreibung in Verbindung mit der Zeichnung zu entnehmen.

Hierbei zeigen :
- Fig. 1: eine schematische Querschnittsdarstellung der erfindungsgemäßen Positionierungsvorrichtung gemäß einer Ausführungsform der Erfindung ;
- Fig. 2: eine Draufsicht einer vorbestimmten Stelle mit Bondkontakten für die Verwendung innerhalb der erfindungsgemäßen Positionierungsvorrichtung ; und
- Fig. 3: eine schematische Darstellung eines zeitlichen Verfahrensablaufes gemäß einer Ausführungsform des erfindungsgemäßen Positionierungsverfahrens in Verbindung mit einer Draufsicht eines Abschnitts eines zweiten Trägers.

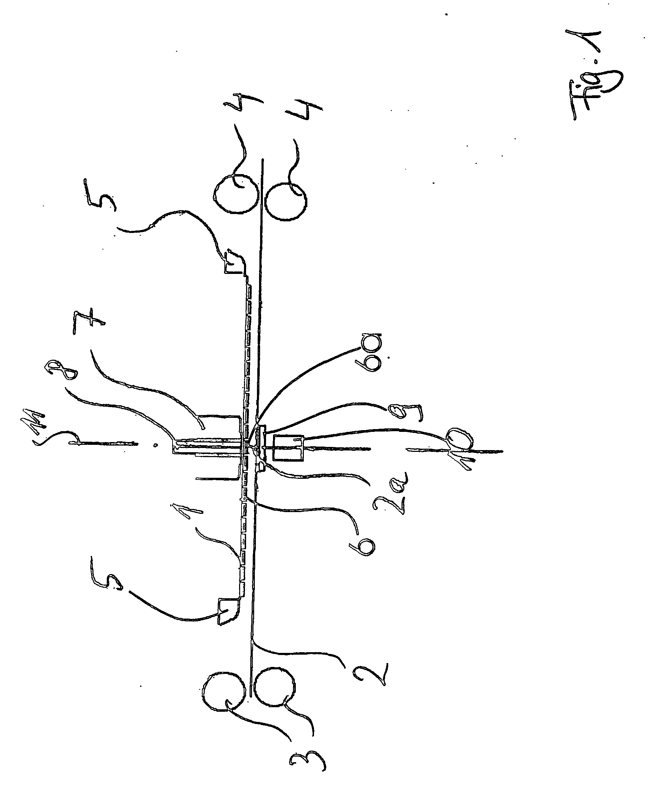

In Fig. 1 wird in einer schematischen Querschnittsdarstellung eine Positionierungsvorrichtung gemäß einer Ausführungsform der Erfindung gezeigt. Ein auf einer Trägerfolie angeordneter Wafer 1 ist oberhalb und parallel zu einem bandartigen Substrat 2, welches mittels Antriebsrollen 3, 4 von links nach rechts und vice versa sowie vorzugsweise zusätzlich in die Bildebene hinein und vice versa verschoben werden kann, angeordnet. Der Wafer 1 kann mittels einer Waferhalterung 5 innerhalb der Waferebene, also in X- und Y-Richtung verschoben und zusätzlich um eine senkrecht zu der Waferebene stehende Rotationsachse gedreht werden. Dies erlaubt eine genaue Ausrichtung eines ausgewählten von der Trägerfolie-abzulösenden Chips 6a aus einer Mehrzahl von Chips 6 auf eine vorbestimmte Stelle des Substrates 2, die als Bondposition 2a Bondkontakte aufweist.

Eine Ausstoßeinrichtung 7 umfasst eine Ausstechnadel 8, die mittels einer Ausstoßbewegung in Z-Richtung, also einer Bewegung nach unten, auf die Rückseite des abzulösenden Chips 6a wirkt und diesen von der Trägerfolie ablöst. Auf diese Weise wird der abgelöste Chip 6a auf die Bondposition 2a abgelegt und an dieser Stelle mit den Bondkontakten verbunden. Hierfür weist die Vorrichtung ein flächenhaftes Auflageelement 9 auf, das zur Unterstützung des Bondvorganges beheizt werden kann.

Sowohl das Auflageelement 9 als auch das Substratmaterial des Substrates 2 sind optisch transparent, um einen optischen Kontakt einer Kameraeinrichtung 10, die unterhalb des Auflageelements 9 angeordnet ist, sowohl auf den abzulösenden Chip 6a und die Ausstoßeinrichtung 7 als auch auf die Bondposition 2a zu ermöglichen. Das Substratmaterial kann hierfür aus einem Kunststoff auf Polymerbasis, wie beispielsweise aus PE, PET, PV oder Polyamid bestehen.

Das Substratmaterial ist zusätzlich beispielsweise mittels photochemischer Prozesse oder einem Druckverfahren mit Antennenspulen versehen, die über die ebenso bereits auf dem Substratmaterial angeordneten Bondkontakte mit dem zu bondenden Chip verbunden werden sollen.

Wie der Fig. 1 deutlich zu entnehmen ist, sind die Kameraeinrichtung 10, die Bondposition 2a, der abzulösende Chip 6a und die Ausstoßeinrichtung 7 mit ihren Mittelachsen auf einer gedachten gemeinsamen Gerade 11 angeordnet, die ein Ausrichten dieser Elemente mit hoher Genauigkeit zulässt.

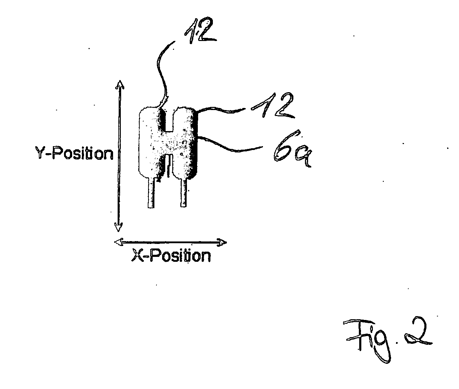

In Fig. 2 ist in einer Draufsicht eine mögliche Form der vorbestimmten Stelle 2a, wie sie in der Positionierungsvorrichtung gemäß einer weiteren Ausführungsform in welcher die Ausstoßrichtung nicht positionierbar ist, verwendet werden kann, dargestellt. Eine derartige Bondposition 2a besteht im Wesentlichen aus zwei Bondkontaktanschlüssen 12, die in diesem dargestellten Layout den Vorteil aufweisen, dass auf eine Positionierungseinrichtung für die Ausstoßeinrichtung 7 verzichtet werden kann, da die Flächen der Bondkontaktanschlüsse 12 im Vergleich zu der Größe des zu bondenden Chips 6a relativ groß sind. Dies betrifft insbesondere die längliche Ausdehnung der Bondkontaktanschlüsse 12 in Y-Richtung.

Hierfür ist die Ausstoßeinrichtung 7 bezüglich des Mittelpunktes der Kameraeinrichtung 10 fest positioniert. Die Position des Chips 6a wird während einer Transportbewegung des Substrates 2 ermittelt. Mittels der ermittelten Positionsdaten wird der Chip mit Hilfe der Positionierungseinrichtung der Waferhalterung 5 auf den Nullpunkt der Kameraeinrichtung, also auf die Gerade 11 ausgerichtet. Nachdem eine Transportbewegung des Substrates erfolgt ist, werden die Positionsdaten der Bondkontakte 12 mittels der Kameraeinrichtung erfasst. Anschließend wird das Substrat mittels der Antriebsrollen 3, 4 derart in X-Richtung verschoben, dass die Bondkontakte 12 genau unter dem zu bondenden Chip ausgerichtet sind. anschließend findet eine Z-Bewegung der Ausstoßeinrichtung statt, um den Chip von der Trägerfolie zu lösen und auf den Bondkontakte anzuordnen.

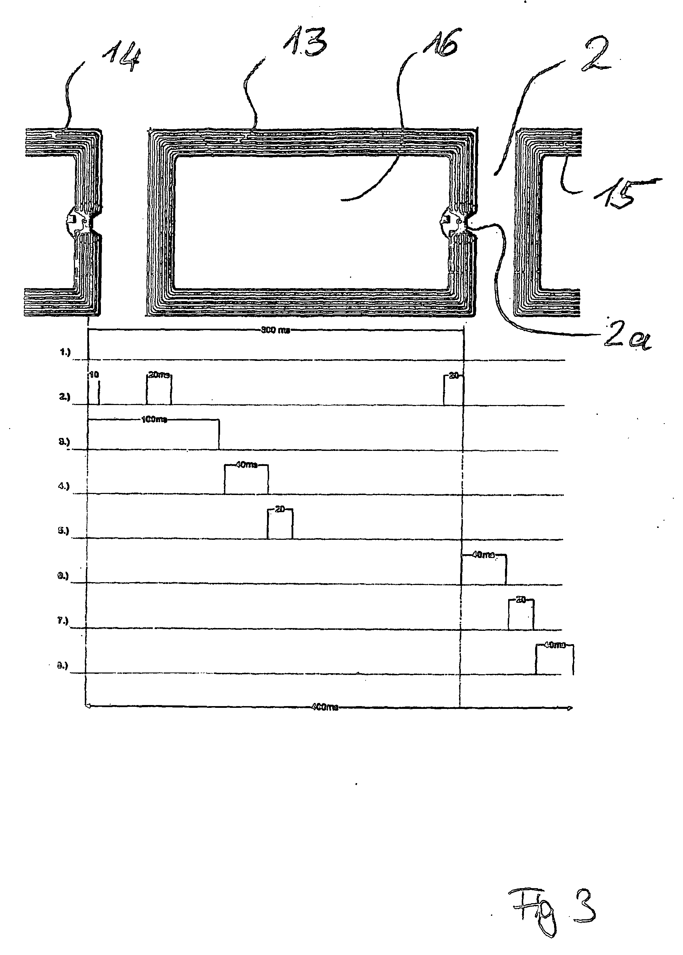

In Fig. 3 wird in einer schematischen Darstellung eine mögliche Ausführungsform des erfindungsgemäßen Positionierungsverfahrens dargestellt. Zudem wird in einer Draufsicht eine mögliche Anordnung von Antennenschleifen 13, 14 und 15 auf einem optisch transparenten Substrat 2 mit dazwischen- und darinliegenden optisch transparenten Bereichen 16 gezeigt.

Der in Form von 8 verschiedenen Zeitsignalen gezeigte zeitliche Ablauf einer möglichen Ausführungsform des erfindungsgemäßen Positionierungsverfahrens erstreckt sich über eine Zeitspanne von insgesamt 400 ms und gibt unter anderem dem Vorgang eine Verschiebebewegung des Substrates während der Erfassung der Positionsdaten des Chips und der Ausstoßeinrichtung wieder.

Unter 1.) wird die Zeitspanne von 300 ms für eine Verschiebebewegung des Substrates 2 von der einen zu der nächsten Bondposition 2a dargestellt. Unter 2.) werden diejenigen Zeitspannen dargestellt, in welchen die Antennen 13,14, und 12 der Kameraeinrichtung keinen optischen Kontakt zu dem Chip erlauben.

Unter 3.) wird diejenige Zeit angegeben, die benötigt wird, um den Wafer bezüglich der Kameraeinrichtung derart zu verschieben, dass der nächste Chip mit seinen Positionsdaten erfasst werden kann. Anschließend findet eine Positionsdatenerfassung innerhalb der unter 4.) angegebenen Zeitspanne von 40 ms statt. Eine nachträglich auszuführende Korrekturverschiebung des Chips benötigt 20 ms, wie es unter 5.) angegeben ist.

Nun wird - wie unter 6.) gezeigt - eine Positionsdatenerfassung der Bondkontaktanschlüsse und anschließend eine gegebenenfalls notwendige Korrekturverschiebung des bandartigen Substrates oder des Chips, wie es unter 7.) dargestellt wird, durchgeführt. Auf diese Weise wird eine gegenseitige Ausrichtung der Bondkontaktanschlüsse zu dem zu bondenden Chip und gegebenenfalls der Ausstoßeinrichtung auf eine gemeinsame Gerade erhalten.

Unter 8.) findet für eine Zeitspanne von 40 ms der eigentliche Bondvorgang statt, um den Chip mit den Bondkontaktanschlüssen zu verbinden.

## Patentansprüche

1. Positionierungsvorrichtung, umfassend:
- einen ersten flachen Träger (1),
- einen zweiten flachen Träger (2), der sich parallel zu dem ersten flachen Träger (1) erstreckt, wobei die Positionierungsvorrichtung dazu ausgebildet ist, mindestens ein elektronisches Bauteil (6, 6a) von dem ersten flachen Träger (1) zu mindestens einer vorgegebenen Bondposition (2a) auf dem zweiten flachen Träger (2) zu übertragen,
- eine Ausstoßeinrichtung (7, 8) zur Entnahme des mindestens einen elektronischen Bauteils (6a) von dem ersten flachen Träger (1) durch eine Ausstoßbewegung, und
- eine Kameraeinrichtung (10) zum Erfassen von Positionsdaten der mindestens einen vorbestimmten Bondposition (2a) und des mindestens einen elektrischen Bauteils (6a), das von dem ersten flachen Träger (1) entnommen wird, wobei die Kameraeinrichtung (10), ein flächenhaftes Auflageelement (9) der Positionierungsvorrichtung, der zweite flache Träger (2), der erste flache Träger (1) und die Ausstoßeinrichtung (7, 8) in dieser Reihenfolge im Wesentlichen auf einer gedachten gemeinsamen Geraden (11) angeordnet sind,
**dadurch gekennzeichnet,**
**dass** das flächenhafte Auflageelement (9) aus einem optisch transparenten Material besteht, und der zweite flache Träger (2) zumindest stellenweise aus einem optisch transparenten Material besteht, um der Kameraeinrichtung (10) einen optischen Kontakt sowohl auf das mindestens eine elektrische Bauteil (6, 6a), das entnommen wird, als auch auf die Bondposition (2a) zu ermöglichen.

2. Positionierungsvorrichtung nach Anspruch 1, **dadurch gekennzeichnet, dass** der erste flache Träger (1) mit einer ersten Positionierungseinrichtung (5) und der zweite flache Träger (2) mit einer zweiten Positionierungseinrichtung (3, 4) zum Positionieren des ersten flachen Trägers (1) und des zweiten flachen Trägers (2) bezüglich der gedachten gemeinsamen Geraden (11) ist, und wobei der zweite flache Träger (2) in seiner Trägerebene mit einer Verschiebungsgeschwindigkeit verschoben wird, welche berechnet wird aus:
- dem Abstand zwischen den von dem ersten flachen Träger (1) sukzessive zu entnehmenden elektronischen Bauteilen,
- einer Verschiebungsgeschwindigkeit des ersten flachen Trägers (1), und
- den Positionsdaten des optisch transparenten Bereichs (16) des zweiten flachen Trägers (2), durch welche die Kameraeinrichtung (10) Positionsdaten während des Verschiebens des zweiten flachen Trägers (2) erfasst.

3. Positionierungsvorrichtung nach Anspruch 2, **dadurch gekennzeichnet, dass** eine Verschiebung des ersten flachen Trägers (1) und des zweiten flachen Trägers (2) in deren jeweiligen Trägerebenen mittels der ersten Positionierungseinrichtung (5) und der zweiten Positionierungseinrichtung (3, 4) durchführbar ist.

4. Positionierungsvorrichtung nach Anspruch 2 oder 3, **dadurch gekennzeichnet, dass** eine Rotation des ersten flachen Trägers (1) und/oder des zweiten flachen Trägers (2) um eine senkrecht zu den Trägerebenen stehende Rotationsachse mittels der ersten Positionierungseinrichtung (5) und der zweiten Positionierungseinrichtung (3, 4) durchführbar ist.

5. Positionierungsvorrichtung nach einem der vorhergehenden Ansprüche, **dadurch gekennzeichnet, dass** die Ausstoßeinrichtung (7, 8) mit einer dritten Positionierungseinrichtung zum Positionieren der Ausstoßeinrichtung (7, 8) bezüglich der gedachten gemeinsamen Geraden (11), mittels einer parallel zu dem ersten und zweiten flachen Träger (1, 2) durchgeführten Verschiebung verbunden ist.

6. Positionierungsvorrichtung nach Anspruch 1, **dadurch gekennzeichnet, dass** der zweite flache Träger (2) als bandartiges Substrat ausgebildet ist.

7. Positionierungsvorrichtung nach Anspruch 6, **dadurch gekennzeichnet, dass** das bandartige Substrat aus einem optisch transparenten Material besteht.

8. Positionierungsvorrichtung nach Anspruch 1 oder 6, **dadurch gekennzeichnet, dass** das bandartige Substrat aus einem teilweise durchbrochenen Material besteht.

9. Positionierungsvorrichtung nach Anspruch 1, **dadurch gekennzeichnet, dass** auf dem zweiten flachen Träger (2) weitere elektronische Bauteile (13, 14, 15) angeordnet sind, bevor das wenigstens eine elektronische Bauteil (6a) übertragen wird.

10. Positionierungsvorrichtung nach Anspruch 9, **dadurch gekennzeichnet, dass** Bondkontakte (12) zum Bonden des wenigstens einen elektrischen Bauteils (6a) an den vorbestimmten Bondpositionen (2a) des zweiten flachen Trägers (2) angeordnet sind.

11. Positionierungsvorrichtung nach Anspruch 1, **dadurch gekennzeichnet, dass** die Kameraeinrichtung (10) unterhalb des zweiten flachen Trägers (2) angeordnet ist, und sich die gemeinsame gedachte Gerade (11) in vertikaler Richtung durch die Kameraeinrichtung (10) hindurch erstreckt.

12. Positionierungsvorrichtung nach einem der vorhergehenden Ansprüche, **dadurch gekennzeichnet, dass** das flächenhafte Auflageelement (9) zwischen der Kameraeinrichtung (10) und dem zweiten flachen Träger (2) zum Auflegen eines Teils des zweiten flachen Trägers (2), das aus einem optisch transparenten Material besteht, angeordnet ist.

13. Positionierungsvorrichtung nach Anspruch 1, **dadurch gekennzeichnet, dass** das flächenhafte Auflageelement (9) entlang der vertikalen Achse verschiebbar ist.

14. Positionierungsverfahren zum Übertragen mindestens eines elektronischen Bauteils (6, 6a) von einem ersten flachen Träger (1) zu mindestens einer vorbestimmten Bondposition (2a) auf einem zweiten flachen Träger (2), der sich parallel zu dem ersten flachen Träger (1) erstreckt, mit einer Ausstoßeinrichtung (7, 8) zur Entnahme des mindestens einen Bauteils (6a) von dem ersten flachen Träger (1) durch eine Ausstoßbewegung,
**gekennzeichnet durch** die folgenden Schritte:
- Verschieben des zweiten flachen Trägers (2) entlang seiner Trägerebene unterhalb des ersten flachen Trägers (1);
- Erfassen von Positionsdaten, während des Verschiebens des zweiten flachen Trägers (2), des mindestens einen elektronischen Bauteils (6a), das auf dem ersten flachen Träger (1) angeordnet ist, mittels einer Kameraeinrichtung (10), die unterhalb des zweiten flachen Trägers (2) angeordnet ist, welcher zumindest stellenweise optisch transparent ist;
- Positionieren einer vorbestimmten Bondposition (2a) auf dem zweiten flachen Träger (2) oberhalb der Kameraeinrichtung (10);
- Erfassen von Positionsdaten der vorbestimmten Bondposition (2a) mittels der Kameraeinrichtung (10); und
- Ausrichten des ersten flachen Trägers (1) und/oder des zweiten flachen Trägers (2) **durch** Verschieben derjenigen zueinander innerhalb der jeweiligen Trägerebenen mittels Positionierungseinrichtungen (5; 3, 4), die mit den Trägern (1; 2) verbunden sind, so dass die Kameraeinrichtung (10), die vorgegebene Bondposition (2a) auf dem zweiten flachen Träger (2), das mindestens eine elektrische Bauteil (6a), das auf dem ersten flachen Träger (1) angeordnet ist, und die Ausstoßeinrichtung (7, 8) auf einer gedachten gemeinsamen Geraden (11) liegen, und wobei
- der zweite flache Träger (2) in einer zweiten Trägerebene mit einer Verschiebungsgeschwindigkeit bewegt wird, welche aus dem Abstand zwischen den von dem ersten flachen Träger (1) sukzessive zu entnehmenden elektronischen Bauteilen (6a), einer Verschiebungsgeschwindigkeit des ersten flachen Trägers (1), und Positionsdaten eines optisch transparenten Bereichs des zweiten flachen Trägers (2), **durch** welche die Kameraeinrichtung (10) Positionsdaten während des Verschiebens des zweiten flachen Trägers (2) erfasst, berechnet wird.

15. Positionierungsverfahren nach Anspruch 14,
wobei der zweite flache Träger (2) als bandartiges Substrat ausgebildet ist,
wobei der erste flache Träger (1) als Wafer ausgebildet ist, und
wobei der Vorgang der Verschiebungsbewegung des Substrates während der Erfassung der Positionsdaten des mindestens einen elektronischen Bauteils (6, 6a) und der mindestens einen vorbestimmten Bondposition (2a) auf dem zweiten flachen Träger (2), weiter umfasst:
- einen ersten Schritt, in dem eine Verschiebebewegung des Substrates von einer ersten Bondposition zu einer zweiten Bondposition auf dem zweiten flachen Träger (2) durchgeführt wird,
- einen zweiten Schritt, in dem die Kameraeinrichtung (10) keinen optischen Kontakt zu den elektronischen Bauteil (6, 6a) hat,
- einen dritten Schritt, in dem der Wafer bezüglich der Kameraeinrichtung (10) derart verschoben wird, dass ein nächstes elektronisches Bauteil mit seinen Positionsdaten erfasst werden kann,
- einen vierten Schritt, in dem die Positionsdaten erfasst werden,
- einen fünften Schritt, in dem eine nachträglich auszuführende Korrekturverschiebung des elektronischen Bauteils durchgeführt werden kann,
- einen sechsten Schritt, in dem die Positionsdaten von Bondkontaktanschlüssen (12) erfasst werden,
- einen siebten Schritt, in dem notwendige Korrekturverschiebungen des bandartigen Substrates oder des elektronischen Bauteils durchgeführt werden, wobei die Bondkontaktanschlüsse (12) und das zu bondende elektronische Bauteil und optional die Ausstoßeinrichtung (7, 8) gegenseitig auf eine gedachte gemeinsame Gerade (11) ausgerichtet werden, und
- einen achten Schritt, in dem das Bonden zum Bonden des elektronischen Bauteils auf den Bondkontaktstellen durchgeführt wird.

16. Positionierungsverfahren nach Anspruch 14 oder 15, **dadurch gekennzeichnet, dass** der erste flache Träger (1) durch eine erste Positionierungseinrichtung (5) und der zweite flache Träger (2) durch eine zweite Positionierungseinrichtung (3, 4) zum Positionieren des ersten flachen Trägers (1) und des zweiten flachen Trägers (2) bezüglich der gedachten gemeinsamen Geraden (11) bewegt werden, und wobei der zweite flache Träger (2) in seiner Trägerebene mit einer Verschiebungsgeschwindigkeit bewegt wird, welche sich berechnet aus:
- einem Abstand zwischen den von dem ersten flachen Träger sukzessive zu entnehmenden elektronischen Bauteilen,
- einer Verschiebungsgeschwindigkeit des ersten flachen Trägers (1), und
- Positionsdaten eines optisch transparenten Bereichs des zweiten flachen Trägers (2), durch welchen die Kameraeinrichtung (10) Positionsdaten während des Verschiebens des zweiten flachen Trägers (2) erfasst.

## Claims

1. Positioning apparatus, comprising:
- a first flat support (1),
- a second flat support (2) which extends parallel to the first support (1), wherein the positioning apparatus is adapted to transfer at least one electronic component (6, 6a) from the first flat support (1) to at least one predefined bond position (2a) on the second flat support (2),
- an ejection device (7, 8) for removing the at least one electronic component (6a) from the first flat support (1) by an ejection movement, and
- a camera device (10) for detecting position data of the at least one predetermined bond position (2a) and of the at least one electronic component (6a) which is removed from the first flat support (1),
wherein the camera device (10), a flat support element (9) of the positioning apparatus, the second flat support (2), the first flat support (1) and the ejection device (7, 8) are generally arranged in this order on an imaginary common straight line (11),
**characterized in that**:
the flat support element (9) comprises an optically transparent material, and the second flat support (2) at least partially comprises optically transparent material, to enable the camera device (10) to optically contact the at least one electronic component (6, 6a) which is removed, as well as the bond position (2a).

2. The apparatus according to claim 1, **characterized in that** the first flat support (1) is with a first positioning device (5) and the second flat support (2) is with a second positioning device (3, 4) to position the first flat support (1) and the second flat support (2) with respect to the imaginary common straight line (11), and wherein the second flat support (2) is displaced in the support plane thereof with a displacement speed, which is calculated from:
- the distance between the electronic components which are to be successively removed from the first flat support (1),
- a displacement speed of the first flat support (1), and
- the position data of the optically transparent region (16) of the second flat support (2), through which the camera device (10) detects position data during displacement of the second flat support (2).

3. Positioning apparatus according to Claim 2, **characterized in that** a displacement of the first and second flat support (1, 2) in the support planes thereof can be carried out by means of the first and second positioning device (5; 3, 4) respectively.

4. Positioning apparatus according to Claim 2 or 3, **characterized in that** a rotation of the first and/or second support (1, 2) about a rotation axis perpendicular to the support planes thereof can be carried out by means of the first and/or second positioning device (5; 3, 4).

5. Positioning apparatus according to any of the preceding claims, **characterized in that** the ejection device (7, 8) is connected to a third positioning device for positioning it with respect to the common straight line (11) by means of a displacement carried out parallel to the support planes.

6. Positioning apparatus according to Claim 1, **characterized in that** the second flat support (2) is designed as a strip-shaped substrate.

7. Positioning apparatus according to Claim 6, **characterized in that** the strip-shaped substrate consists of an optically transparent material.

8. Positioning apparatus according to Claim 1 or 6, **characterized in that** the strip-shaped substrate consists of a partially perforated material.

9. Positioning apparatus according to Claim 1, **characterized in that** further components (13, 14, 15) which were applied prior to the transfer of the electronic component (6a) are arranged on the second flat support (2).

10. Positioning apparatus according to Claim 9, **characterized in that** bond contacts (12) for bonding the at least one electronic component (6a) are arranged at the predetermined locations (2a) of the second flat support (2).

11. Positioning apparatus according to Claim 1, **characterized in that** the camera device (10) is arranged below the second support (2) and the common straight line (11) extends through the camera device (10) in the vertical direction.

12. Positioning apparatus according to any of the preceding claims, **characterized in that** the flat support element (9) for supporting part of the second support (2) made of optically transparent material is arranged between the camera device (10) and the second support (2).

13. Positioning apparatus according to Claim 13, **characterized in that** the support element (9) can be displaced along the straight line (11) in the vertical direction.

14. Positioning method for transferring at least one electronic component (6, 6a) from a first flat support (1) to at least one predetermined location (2a) on a second flat support (2) which extends parallel to the first support, comprising an ejection device (7, 8) for removing the component (6a) from the first support (1) by means of an ejection movement, **characterized by** the following steps:
- displacing the second flat support (2) along its support plane below the first flat support (1);
- detecting position data of the electronic component (6a) arranged on the first support (1) by means of a camera device (10) arranged below the second support (2) consisting of a material which is optically transparent at least in some regions, during displacement of the second support (2);
- positioning a predetermined bond location (2a) on the second support (2) above the camera device (10);
- detecting position data of the predetermined location (2a) by means of the camera device (10); and
- aligning the first support (1) and/or the second support (2) by means of positioning devices (5; 3, 4) connected thereto, by displacement and/or rotation thereof with respect to one another within the support planes, such that the camera device (10), the predetermined bond location (2a) on the second support (2), the at least one electronic component (6a) arranged on the first support (1) and the ejection device (7, 8) lie on a imaginary common straight line (11), and wherein
- the second flat support (2) is moved in a second support plane with a displacement speed which is calculated from the distance between the electronic components (6a) which are to be successively removed from the first flat support (2), through which the camera device (10) detects position data during displacement of the second flat support (2).

15. The positioning method according to claim 14,
wherein the second flat support (2) is designed as a strip-shape substrate,
wherein the first flat support (1) is desgined as a wafer, and
wherein the step of moving the substrate while detecting position data of the at least one electronic component (6, 6a) and the at least one predetermined bond position (2a) on the second flat support (2) further comprises:
- a first step, in which a displacement movement of the substate from a first bond position to a second bond position on the second flat support (2) is carried out,
- a second step, in which the camera device (10) has no optical contact to the electronic component (6, 6a)
- a third step, in which the wafer is moved with respect to the camera device (10) in such a way that a next electronic component and its position data can be detected,
- a fourth step, in which the position data are detected,
- a fifth step, in which a correction movement of the electronic component, which is to be carried out afterwards, can be carried out,
- a sixth step, in which the position data of bond contact connections (12) are detected,
- a seventh step, in which the necessary correction movement of the substrate or of the electronci component is carried out, wherein the bond contact connections (12) and the electronic component which is to be bonded and optionally the ejection device (7, 8) are arranged on an imaginary common straight line (11), and
- an eighth step, in which the bonding-to-bonding of the electronic component on the bond contact connections is carried out.

16. The positioning method according to claim 14 or 15, **characterized in that** the first flat support (1) is moved with a first positioning device (5) and the second flat support (2) is moved with a second positioning device (3, 4) to position the first flat support (1) and the second flat support (2) with respect to the imaginary common straight line (11), and wherein the second flat support (2) is displaced in the support plane thereof with a displacement speed, which is calculated from:
- a distance between the electronic components which are to be successively removed from the first flat support,
- a displacement speed of the first flat support (1), and
- position data of an optically transparent region of the second flat support (2), through which the camera device (10) detects position data during displacement of the second flat support (2).

## Revendications

1. Dispositif de positionnement, comprenant :
- un premier support plat (1),
- un deuxième support plat (2) qui s'étend parallèlement au premier support plat (1), le dispositif de positionnement étant conçu pour transférer au moins un composant électronique (6, 6a) à partir du premier support plat (1) vers au moins une position de connexion dite position de bonding (2a) prédéterminée sur le deuxième support plat (2),
- un système d'éjecteur (7, 8) pour le prélèvement dudit au moins un composant électronique (6a) du premier support plat (1), par un mouvement d'éjection, et
- un système de caméra (10) destiné à relever des données de position de ladite au moins une position de bonding (2a) prédéterminée et dudit au moins un composant électrique (6a) qui est prélevé du premier support plat (1), le système de caméra (10), un élément d'appui de surface (9) du dispositif de positionnement, le deuxième support plat (2), le premier support plat (1) et le système d'éjecteur (7, 8) étant agencés selon cet ordre sur une droite fictive commune (11),
**caractérisé en ce que**
l'élément d'appui de surface (9) est réalisé en un matériau optiquement transparent, et **en ce que** le deuxième support plat (2) est réalisé, au moins dans certaines zones, en un matériau optiquement transparent, afin de permettre au système de caméra (10) de disposer d'un contact optique aussi bien vers ledit au moins un composant électrique (6, 6a) qui est prélevé, que vers la position de bonding (2a).

2. Dispositif de positionnement selon la revendication 1, **caractérisé en ce que** le premier support plat (1) est relié à un premier système de positionnement (5) et le deuxième support plat (2) à un deuxième système de positionnement (3, 4) pour positionner le premier support plat (1) et le deuxième support plat (2) par rapport à la droite fictive commune (11), le deuxième support plat (2) étant déplacé en translation dans son plan de support, avec une vitesse de déplacement en translation, qui est calculée à partir :
- de la distance entre les composants électroniques devant être prélevés successivement du premier support plat (1),
- d'une vitesse de déplacement en translation du premier support plat (1), et
- des données de position de la zone optiquement transparente (16) du deuxième support plat (2), par laquelle le système de caméra (10) relève des données de position pendant le déplacement en translation du deuxième support plat (2).

3. Dispositif de positionnement selon la revendication 2, **caractérisé en ce qu'**un déplacement en translation du premier support plat (1) et du deuxième support plat (2) dans leurs plans de support respectifs peut être effectué au moyen du premier système de positionnement (5) et du deuxième système de positionnement (3, 4).

4. Dispositif de positionnement selon les revendications 2 ou 3, **caractérisé en ce qu'**une rotation du premier support plat (1) et/ou du deuxième support plat (2) autour d'un axe de rotation perpendiculaire aux plans des supports peut être effectuée au moyen du premier système de positionnement (5) et du deuxième système de positionnement (3, 4).

5. Dispositif de positionnement selon l'une des revendications précédentes, **caractérisé en ce que** le système d'éjecteur (7, 8) est relié à un troisième système de positionnement pour positionner le système d'éjecteur (7, 8) par rapport à la droite fictive commune (11), au moyen d'un déplacement en translation effectué parallèlement au premier et au deuxième support plat (1, 2).

6. Dispositif de positionnement selon la revendication 1, **caractérisé en ce que** le deuxième support plat (2) est réalisé en tant que substrat en forme de bande.

7. Dispositif de positionnement selon la revendication 6, **caractérisé en ce que** le substrat en forme de bande est réalisé en un matériau optiquement transparent.

8. Dispositif de positionnement selon les revendications 1 ou 6, **caractérisé en ce que** le substrat en forme de bande est réalisé en un matériau en partie ajouré.

9. Dispositif de positionnement selon la revendication 1, **caractérisé en ce que** sur le deuxième support plat (2) sont agencés d'autres composants électroniques (13, 14, 15), avant que ne soit transféré ledit au moins un composant électronique (6a).

10. Dispositif de positionnement selon la revendication 9, **caractérisé en ce que** des contacts de liaison dits contacts de bonding (12) sont agencés au niveau des positions de connexion prédéterminées dites postions de bonding (2a) du deuxième support plat (2) pour assurer la connexion dudit au moins un composant électrique (6a).

11. Dispositif de positionnement selon la revendication 1, **caractérisé en ce que** le système de caméra (10) est agencé en dessous du deuxième support plat (2), et la droite fictive commune (11) s'étend dans une direction verticale en passant par le système de caméra (10).

12. Dispositif de positionnement selon l'une des revendications précédentes, **caractérisé en ce que** l'élément d'appui de surface (9) est agencé entre le système de caméra (10) et le deuxième support plat (2), afin qu'une partie du deuxième support plat (2) réalisée en un matériau optiquement transparent puisse y prendre appui.

13. Dispositif de positionnement selon la revendication 1, **caractérisé en ce que** l'élément d'appui de surface (9) peut être déplacé en translation le long de l'axe vertical.

14. Procédé de positionnement pour assurer le transfert d'au moins un composant électronique (6, 6a) à partir d'un premier support plat (1) vers au moins une position de bonding (2a) prédéterminée sur un deuxième support plat (2) s'étendant parallèlement au premier support plat (1), comportant un système d'éjecteur (7, 8) pour le prélèvement dudit au moins un composant (6a) du premier support plat (1) par un mouvement d'éjection,
**caractérisé par** les étapes suivantes consistant à :
- déplacer en translation le deuxième support plat (2) le long de son plan de support en dessous le premier support plat (1) ;
- relever des données de position, pendant le déplacement en translation du deuxième support plat (2), dudit au moins un composant électronique (6a) agencé sur le premier support plat (1), au moyen d'un système de caméra (10) agencé en dessous du deuxième support plat (2) qui est optiquement transparent au moins dans certaines zones ;
- positionner une position de bonding (2a) prédéterminée sur le deuxième support plat (2), au-dessus du système de caméra (10) ;
- relever des données de position de la position de bonding (2a) prédéterminée, au moyen du système de caméra (10) ; et
- aligner le premier support plat (1) et/ou le deuxième support plat (2) par déplacement en translation de ceux-ci l'un par rapport à l'autre à l'intérieur de leur plan de support respectif au moyen de systèmes de positionnement (5 ; 3, 4), qui sont reliés aux supports (1 ; 2), de manière à ce que le système de caméra (10), la position de bonding (2a) prédéterminée sur le deuxième support plat (2), ledit au moins un composant électrique (6a) agencé sur le premier support plat (1), et le système d'éjecteur (7, 8) soient situés sur une droite fictive commune (11), et
- le deuxième support plat (2) étant déplacé en translation dans un deuxième plan de support, avec une vitesse de déplacement en translation qui est calculée à partir de la distance entre les composants électroniques (6a) devant être prélevés successivement du premier support plat (1), d'une vitesse de déplacement en translation du premier support plat (1) et de données de position d'une zone optiquement transparente du deuxième support plat (2), par laquelle le système de caméra (10) relève des données de position pendant le déplacement en translation du deuxième support plat (2).

15. Procédé de positionnement selon la revendication 14,
dans lequel le deuxième support plat (2) est réalisé en tant que substrat en forme de bande,
dans lequel le premier support plat (1) est réalisé en tant que tranche de semi-conducteur, et
dans lequel l'opération du mouvement de déplacement en translation du substrat pendant le relevé des données de position dudit au moins un composant électronique (6, 6a) et de ladite au moins une position de bonding (2a) prédéterminée sur le deuxième support plat (2), comprend en outre :
- une première étape au cours de laquelle on effectue un mouvement de déplacement en translation du substrat d'une première position de bonding vers une deuxième position de bonding sur le deuxième support plat (2),
- une deuxième étape au cours de laquelle le système de caméra (10) ne dispose pas de contact optique vers le composant électronique (6, 6a),
- une troisième étape au cours de laquelle la tranche de semi-conducteur est déplacée en translation par rapport au système de caméra (10) de manière à ce qu'il soit possible de relever les données de position d'un composant électronique suivant,
- une quatrième étape au cours de laquelle sont relevées les données de position,
- une cinquième étape au cours de laquelle il est possible d'effectuer un déplacement en translation de correction à exécuter ultérieurement du composant électronique,
- une sixième étape au cours de laquelle sont relevées les données de position de bornes de contact de bonding (12),
- une septième étape au cours de laquelle sont effectués des déplacements en translation de correction nécessaires du substrat en forme de bande ou du composant électronique, les bornes de contact de bonding (12) et le composant électronique devant y être connecté par bonding, et de manière optionnelle, le système d'éjecteur (7, 8) étant alignés réciproquement sur une droite fictive commune (11), et
- une huitième étape au cours de laquelle est effectué l'opération de bonding, pour assurer la connexion par bonding du composant électronique sur les bornes de contact de bonding.

16. Procédé de positionnement selon les revendications 14 ou 15, **caractérisé en ce que** le premier support plat (1) est déplacé par un premier système de positionnement (5) et le deuxième support plat (2) est déplacé par un deuxième système de positionnement (3, 4), afin de positionner le premier support plat (1) et le deuxième support plat (2) par rapport à la droite fictive commune (11), le deuxième support plat (2) étant déplacé en translation dans son plan de support, avec une vitesse de déplacement en translation qui est calculée à partir :
- d'une distance entre les composants électroniques devant être prélevés successivement du premier support plat,
- d'une vitesse de déplacement en translation du premier support plat (1), et
- de données de position d'une zone optiquement transparente du deuxième support plat (2), par laquelle le système de caméra (10) relève des données de position pendant le déplacement en translation du deuxième support plat (2).
